# EUROPEAN PATENT SPECIFICATION

(11) **EP 0 449 951 B1**
(45) Date of publication and mention of the grant of the patent: **15.03.1995**
(21) Application number: 90901362.5
(22) Date of filing: 13.12.1989
(51) Int. Cl.: H01L 29/24, H01L 29/861

(54) **ULTRA-FAST HIGH TEMPERATURE RECTIFYING DIODE FORMED IN SILICON CARBIDE**
ULTRASCHNELLE HOCHTEMPERATUR-GLEICHRICHTERDIODE, EINGEBAUT IN SILICIUM CARBID
DIODE DE REDRESSEMENT HAUTE TEMPERATURE ET ULTRA RAPIDE, CONSTITUEE EN CARBURE DE SILICIUM

(30) Priority: 14.12.1988 US 284035; 06.09.1989 US 403690
(43) Date of publication of application: 09.10.1991
(73) Proprietor: CREE RESEARCH, INC., Durham, North Carolina 27713 (US)
(72) Inventor: EDMOND, John, A., Apex, NC 27502 (US)
(74) Representative: Warren, Anthony Robert
(86) International application number: US8905554
(87) International publication number: WO9007192

(56) References cited:
- Journal of Applied Physics, vol. 48, no. 11, November 1977, American Institute of Physics, W.v.Muench et al.: "Breakdown field in vapor-grown silicon carbide p-n junctions", pp. 4831-4833
- Soviet Physics Semiconductors, vol. 22, no. 2, February 1988, American Institute of Physics, (New York, N.Y., US), M.M. Anikin et al.: "Electrical characteristics of epitaxial p+-n-n+ structures made of the 6H polytype of silicon carbide", pp. 181-183

## Description

### Field of the Invention

The present invention relates to rectifiers formed from semiconductor materials, and in particular relates to a high temperature high frequency rectifying diode formed in silicon carbide.

### Background of the Invention

Power electronics technology is the field of engineering which deals with the conversion, control and conditioning of electric power utilizing electronic power devices. Electronic power can be controlled as to its basic form (alternating or direct current) its effective voltage or current, its frequency and its power. In turn, the control of electric power is frequently used to maintain or achieve a regulation of some other non-electrical factors such as the speed of a motor, the temperature of a heating device or the measurement or generation of light. Control of electric power is likewise used in logic circuits which form the basis for the operation, control and applications of electronic computers.

In current technology, solid state devices have achieved nearly universal acceptance in most applications for such conversion, control and conditioning of electrical power, as well as in the computer industry. Semiconductor devices exhibit greater reliability, faster speed, higher efficiency, smaller size and often lower cost.

One basic type of solid state device is the rectifier diode. As is known to those familiar with electronic devices, diodes are the simplest kind of semiconductor device and the most straightforward use of diodes is rectification: i.e. the conversion of alternating current to direct current. Diodes act as one-way barriers to the passage of electrons in that they permit electrons to flow in one direction but bar their passage in the other direction. Thus, diodes are useful as switching devices. In electronics terminology, a diode is said to pass current in the forward direction ("forward bias") and block current in the reverse direction ("reverse bias"). The characteristics of any given diode can generally be determined by the relationship between the voltage (V) applied to the diode and the current (I).

As is further known to those familiar with electronic devices, however, current is never always completely blocked in the reverse direction. When a reverse voltage (V_{R}) is applied, a small amount of reverse current (I_{R}) will flow through the diode. The reverse current of any diode is therefore defined as the amount of current which will flow at a given reverse voltage. Under conditions of reverse voltage, however, an amount of voltage will finally be reached where the rectifying or electron blocking capability of the diode begins to break down completely. This point is called the reverse breakdown voltage (V_{BR}) and represents the point at which the diode undergoes avalanche multiplication or tunneling of carriers in the depletion region. At this voltage, current will increase dramatically, and if not limited, will generally destroy the diode because of the high wattage and destructive heat that results.

In general, the performance of a diode can thus be characterized using five basic characteristics:
Forward current (I_{F}), the amount of current the diode can handle without burning up;
Forward voltage (V_{F}), the voltage level necessary to produce the desired forward current level;
Reverse current (I_{R}), the amount of current that will leak through the diode at a given reverse voltage;
Reverse breakdown voltage (V_{BR}), the reverse voltage beyond which the flow of reverse current begins to rise very rapidly; and
Reverse recovery time (tᵣᵣ), the time it takes the diode to recover from forward conduction and begin to again block reverse current.

Reverse recovery time is an important characteristic in defining the frequency of alternating current that a given diode or rectifier can handle. The higher the frequency of alternating current which is imposed on the diode, the more quickly the diode must respond in order to rectify this current.

The characteristics of any such device, of course, depend to a great degree upon the material from which the semiconductor device is formed. Different materials have different inherent electronic characteristics and capabilities, and for any given semiconductor material the quality of the devices that can be manufactured will generally depend upon the crystal structure, purity and appropriate doping that can be accomplished with such materials.

Silicon carbide has long been a candidate material for use in the manufacture of such semiconductor electronic devices. Silicon carbide has a number of characteristics which make it theoretically advantageous for such uses. These include a wide band gap, a high thermal conductivity, a low dielectric constant, a high saturated electron drift velocity, a high breakdown electric field, a low minority carrier lifetime, and a high dissociation temperature. Taken together, these properties indicate that semiconductor devices formed from silicon carbide should be operable at much higher temperatures than devices made from other semiconductors, as well as at higher speeds and higher power levels.

Nevertheless, rectifying diodes and other semiconductor electronic devices made from silicon carbide have yet to make a viable appearance in any circumstances other than laboratory research and have yet to reach their commercial potential. This lack of success results, at least partially, from the difficulty encountered in working with silicon carbide. It is an extremely hard material, often used as an abrasive. It often must be worked at extremely high temperatures under which other materials cannot be worked, and from a semiconductor standpoint, crystallizes in well over 150 polytypes, many of which are separated by rather small thermodynamic differences. For these latter reasons, production of monocrystalline thin films of silicon carbide that are necessary for certain devices, and production of large single crystals of silicon carbide which are useful as substrate material and for other applications, have remained elusive goals. Additionally, certain doping techniques which have been successfully developed for other materials have proved unsuccessful when used in connection with silicon carbide. Finally, p-n junctions appropriate for rectifying purposes have yet to make a successful practical and commercial appearance.

Recently, however, a number of developments have occurred which have successfully accomplished both single crystal bulk and thin film growth of silicon carbide. These are included in several United States patents and patent applications. These include the following United States Patents: No. 4,912,063 to Davis et al, "Growth of Beta-SIC Thin Films and Semiconductor Devices Fabricated Thereon" (Serial No. 07/113,921, Filed October 26, 1987); No. 4,912,064 to Davis et al, "Homoepitaxial Growth of Alpha-SIC This Films and Semiconductor Devices Fabricated Thereon" (Serial No. 07/113,573, Filed October 26, 1987); No. 4,865,685 to Palmour, "Dry Etching of Silicon Carbide;" and No. 4,866,005 to Davis et al, "Sublimation of Silicon Carbide to Produce Large, Device Quality Single Crystals of Silicon Carbide."

The production of an appropriate, defined p-n junction of performance quality is a fundamental step in fabricating a rectifying diodes. Accordingly, given the theoretical advantages of silicon carbide and the necessity of producing junctions to develop the devices, including rectifiers, there has been significant interest in methods of producing such junctions in silicon carbide. Most of these efforts have developed methods of producing what may be referred to as "fused" junctions. In such junctions, alternating regions of p-type and n-type silicon carbide are formed in contact with one another to form the p-n junction. Typical techniques have included melting a dopant metal directly on the surface of silicon carbide so that some of the dopant dissolves into the silicon carbide to produce an oppositely doped region, the border of which forms the p-n junction. Others use separately formed portions of p-type and n-type silicon carbide and fuse them to one another using various processes to form the p-n junction. Other techniques attempt to encourage epitaxial growth of p or n-type silicon carbide upon the substrate of silicon carbide having the opposite conductivity type. A number of other methods include solvent based techniques. In a related United States application, successful use of ion implantation techniques has been demonstrated to result in appropriate junctions; "Implantation and Electrical Activation of Dopants Into Monocrystalline Silicon Carbide," Serial No. 07/365,333, Filed May 24, 1989.

Similarly, a number of attempts have been made to produce successful rectifying diodes in silicon carbide. These include rectifying contacts (Schottky Diodes) between particular metals to either n or p-type silicon carbide, the fusion techniques described previously, electric arc or sputtering techniques for depositing a metal rectifying contact to silicon carbide, building stepped transitions between diode materials including silicon carbide, and using a thin layer of glassy amorphous material as an active layer in a rectifying junction device in silicon carbide.

More recently, and as set forth earlier herein, silicon carbide growth techniques using chemical vapor deposition (CVD) to produce high quality epitaxial layers of silicon carbide on both silicon and silicon carbide substrates have been demonstrated. Using these techniques, yet other researchers have attempted to successfully form rectifying diodes in silicon carbide. For example, Kuroda, et al. "Stepped Controlled VPE Growth of SIC Single Crystals at Low Temperatures", Extended Abstracts of The 19th Conference on Solid State Devices and Materials, Tokyo, 1987, pages 227-230, described their attempts to produce diodes in silicon carbide by forming adjacent p and n epitaxial layers using chemical vapor deposition techniques. In their work, Kuroda, et al. report production of a diode that has a reverse breakdown voltage of about 100 volts and a forward current of about 400 microamperes at about 3 volts. Kuroda does not report any reverse recovery time, an important characteristic in a rectifying diode, and produces a graded p-n junction. As known to those familiar with such devices, the characteristics of the junction will essentially define the characteristics of the entire device. A graded junction is one in which a gradient exists between the opposite types of charge carriers (electrons and holes) which can extend for some distance across the junction including distances as great as one or more micrometers. Conversely, an abrupt junction exhibits rapid change from one carrier type to the other. As is further known to those familiar with such devices, one technique for determining whether a junction is graded or abrupt is the use of the measurement of the capacitance of the diode in relationship to the voltage. Generally speaking, when capacitance is plotted directly against voltage, a nonlinear relationship exists. A linear relationship will exist, however, between the reciprocal of the capacitance squared or the reciprocal of the capacitance cubed. If the relationship between the reciprocal of the capacitance squared and the voltage is nonlinear, the diode may be characterized as having an abrupt junction. Alternatively, if the relationship between the reciprocal of capacitance cubed plotted against voltage is linear, the junction can be characterized as graded. As set forth by Kuroda, the diode produced using his techniques exhibits such a graded junction.

Additionally, Kuroda's diode operates in the microamp range, a smaller amount of current capacity than would otherwise be useful in most power requirement applications. Finally, although one desirable characteristic of silicon carbide is its ability to produce blue light, for a rectifying diode a more important characteristic is operation at high temperatures and Kuroda fails to demonstrate any successful diode application at other than room temperature.

An article discussing diodes formed in silicon carbide entitled "Breakdown Field in Vapor-Grown Silicon Carbide p-n Junctions," Journal of Applied Physics, Volume 48, No. 11, November 1977; pages 4831-4833, discusses a diode formed of a p-n junction in which the p-type epitaxial layer is formed upon a p-type substrate.

Furthermore an article by M.M. Anikin et al, "Electrical Characteristics of Epitaxial p+-n-n+ Structures made of the 6H Polytype of Silicon Carbide," Soviet Physics Semiconductors, Volume 22, No. 2, February 1988, pages 181-183, discusses junction structures formed from three epitaxial layers; e.g. p+-n-n+; that are formed upon a silicon carbide substrate, and for which particular operating parameters are reported therein.

Accordingly, it is an object of the present invention to provide a rectifying diode formed in silicon carbide which can operate at high frequency, at high reverse voltage, and at high temperatures, with an abrupt junction and low forward resistance.

The present invention provides a fast recovery, high temperature rectifying diode formed in silicon carbide and comprising:
a monocrystalline silicon carbide substrate having n-type conductivity;
an ohmic contact to said substrate;
a first monocrystalline epitaxial layer of n-type silicon carbide upon said substrate; and
a second monocrystalline epitaxial layer of silicon carbide upon said first epitaxial layer;
characterized in that:
said second epitaxial layer has p-type conductivity and a carrier concentration at least an order of magnitude less than the carrier concentration of said first epitaxial layer so that said second layer is predominantly depleted in reverse bias with said carrier concentration of said second layer being between about 1x10¹⁵ and 1x10¹⁸ atoms per cubic centimeter (cm⁻³), and said second layer further having a minimum thickness of about 0.2 micrometers at a carrier concentration of about 1x10¹⁸ cm⁻³ and that may be increased proportionally to a thickness of about 70 micrometers at a carrier concentration of about 1x10¹⁵ cm⁻³ so that said minimum thickness is sufficient to achieve avalanche breakdown under reverse bias; and
an abrupt p-n junction formed between said first and second epitaxial layers such that the relationship between the reciprocal capacitance squared and the applied voltage is a substantially linear relationship.

The invention will now be further described with reference to the accompanying drawings, which illustrate preferred and exemplary embodiments, and wherein:
Figure 1 is a schematic diagram of the rectifying diode incorporating some of the features of the present invention;
Figure 2 is a perspective view of a circular mesa rectifying diode incorporating some preferred features of the present invention;
Figures 3 and 4 are schematic diagrams of an embodiment of a rectifying diode of the present invention;
Figure 5 is a plot of current versus voltage for a rectifying diode of the type shown in Figure 1 highlighting the reverse leakage current at a bias of -400 volts at both room temperature and at 350°C;
Figure 6 is a plot of current versus voltage in forward bias for a rectifying diode of the type shown in Figure 1 highlighting the forward voltage drop to 400 milliamperes at room temperature and at 350°C;
Figure 7 shows the relationship between capacitance and reverse bias voltage to -20 volts for a diode according to the present invention;
Figure 8 is a plot of the reciprocal of capacitance squared versus gate voltage for a diode of the present invention and showing the linear relationship therebetween;
Figure 9 is a plot of the atomic concentration of aluminum versus depth as determined by secondary ion mass spectrometry (SIMS) for a diode of the type shown in Figure 1;
Figure 10 is a plot of carrier concentration of donors versus depth (depleted to -20 volts reverse bias) in the n-type layer as determined by capacitance-voltage measurements for a 400 volt diode according to the present invention;
Figures 11 and 12 show the relationship between current and time in a switching circuit demonstrating reverse recovery time for a diode according to the present invention operating at room temperature and 350°C respectively;
Figure 13 is a combined plot developed from measured and expected values for reverse breakdown voltage, depletion layer width at breakdown, carrier concentration, and maximum electric field for diodes of the present invention; and
Figures 14 and 15 are plots of current versus voltage for another diode according to the present invention and operating at room temperature and 350°C respectively.

### Detailed Description of the Preferred Embodiment

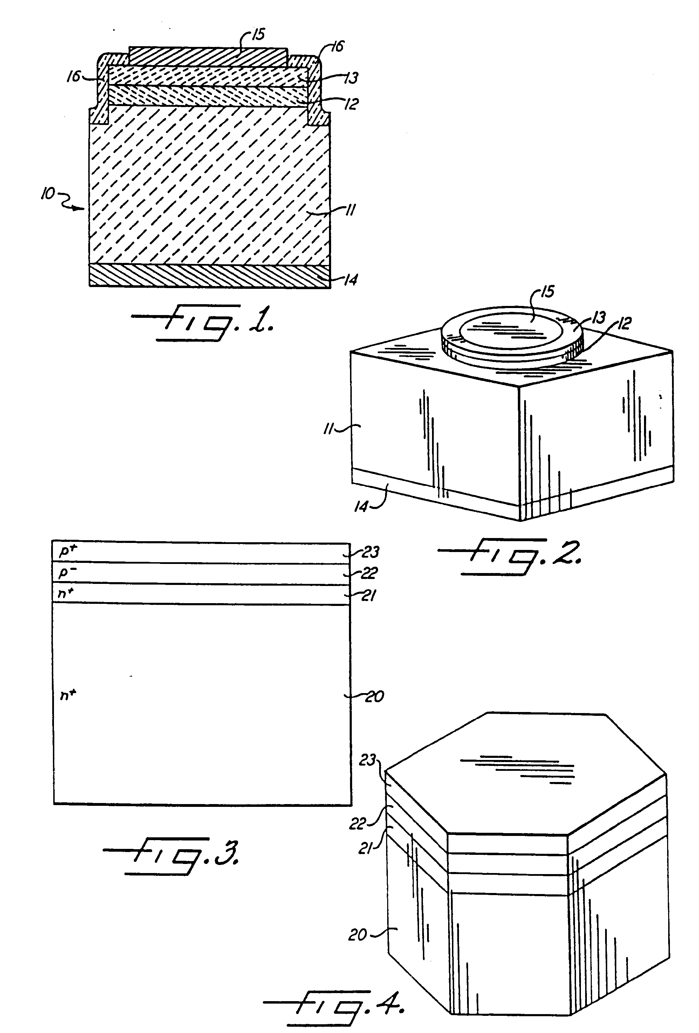

Figure 1 is a schematic diagram of a first embodiment of a rectifying diode similar to the type the present invention is concerned with and generally designated at **10**. The rectifying diode **10** comprises a monocrystalline silicon carbide substrate **11** which has a sufficient carrier concentration to give the substrate **11** an n-type conductivity. As is known to those familiar with electronic devices, the two types of carriers are electrons and holes. Electrons are subatomic particles and holes represent vacant positions in atoms into which electrons can move. As electrons move to such atomic positions, they leave the unfilled positions, i.e. the holes, behind so that the flow of current in any electronic device can be thought of as either the flow of electrons or of holes, with the respective flows moving in opposite directions. As is further known to those familiar with such technology, in a material such as silicon carbide, the carriers generally are introduced by dopants; i.e. atoms which have either a greater or lesser number of electrons per atom in the valance positions than does the semiconductor material itself. Dopants which have a greater number of electrons are known as donor atoms and provide extra electrons. Atoms which have fewer electrons than do the atoms of silicon carbide provide extra holes and are referred to as acceptor atoms.

A first monocrystalline epitaxial layer **12** of silicon carbide is positioned upon the substrate **11** and has the same conductivity type, (ie n-type), as the substrate **11** but has a carrier concentration less than the carrier concentration of the substrate **11**. As the substrate **11** and epitaxial layer **12** are both n-type, the greater number of carriers in the substrate **11** is conventionally designated by the shorthand notation n+, while the lesser or more normal concentration in the first epitaxial layer would be referred to simply as n.

A second monocrystalline epitaxial layer 13 of silicon carbide is positioned upon the first epitaxial layer **12** and has p-type conductivity and has a carrier concentration greater that the concentration of the first epitaxial layer **12** unlike a diode according to the invention. Thus, as in the preceeding discussion where the substrate **11** is n+ and the first epitaxial layer is n, the second layer **13** is designated as p+. The carrier concentration of the p+ epitaxial layer **13** and the carrier concentration of n+ substrate **11** are not necessarily equivalent to one another. As used herein, the general designation p+ or n+ as compared to the general designation n merely indicates that there are more carriers in the substrate **11** than there are in the epitaxial layer **12** and that there are likewise more carriers in the second epitaxial layer **13** than there are in the first epitaxial layer **12**.

In the rectifying diode according to the invention however the carrier concentration of the first layer **12** is greater than the carrier concentration of the second layer **13** so the second layer is predominantly depleted.

As is known to those familiar with rectifying junctions, when the respective carrier concentrations of the p and n sides of the junction differ substantially--i.e. by about an order of magnitude or more--the tendency of the carriers on each side of the junction to move and establish an equilibrium will cause more carriers from one side to move than from the other. Specifically, more carriers from the highly populated side will move to the less populated side. For example, if the junction is p+-n, more holes will move into the n layer than will electrons into the p+ layer. This characteristic will also exhibit itself under reverse bias conditions so that the layer with the lesser carrier concentration will be the layer that is predominantly depleted at reverse bias.

The rectifying diode generally designated at **10** will include an ohmic contact **14** to the substrate and another ohmic contact **15** to the second epitaxial layer. The ohmic contact **14** to the substrate **11** can comprise a metal such as nickel and the ohmic contact **15** to the second epitaxial layer **13** can comprise a metal such as aluminum or a bimetallic contact, for example, formed of an aluminum alloy. In preferred embodiments the rectifying diode can further comprise a passivation layer such as that shown at **16** of silicon dioxide in the vicinity of the p-n junction.

In the diode illustrated in Figure 1, the rectifying diode has a mesa configuration in which epitaxial layers **12** and **13**, along with a portion of substrate **11** have a narrower cross sectional profile than does the remainder of the substrate **11**. In this configuration, individual diodes, which are commonly manufactured in large groups adjacent one another, can be separated without damaging the epitaxial layers, or affecting of the p-n junction, or otherwise changing the quality of the crystal structure. Additionally, the size of the die can be adjusted to handle various current requirements.

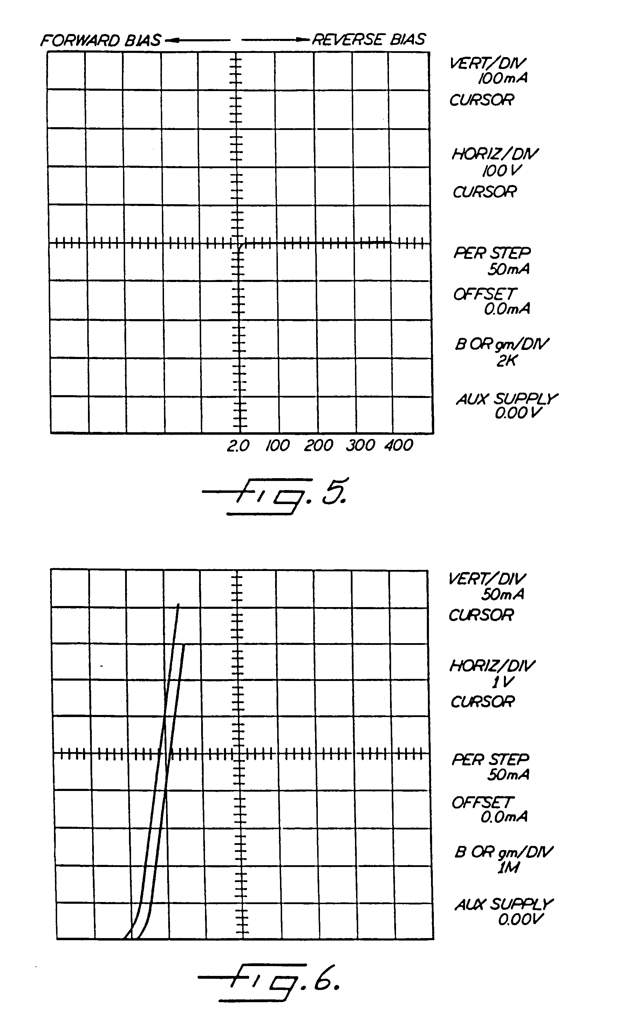

As illustrated in Figure 2, in one embodiment the epitaxial layers **12** and **13** and ohmic contact **15** are generally circular in shape. The resulting circular p-n junction avoids the field effect and charge concentration problems that result from other geometries. Additionally, the shape permits passivation, and as stated above, permits diodes to be sawn apart without damaging their junctions. Alternative constructions such as planar diodes are possible, but would require either diffusion or ion implantation in addition to the epitaxial growth techniques of the present invention.

In terms of actual population, a rectifying diode of the type shown in Figure 1 can be formed so as to have a desired breakdown voltage. The characteristics for such a diode are set forth in Figure 13, wherein it can be seen that, for example, where it is desired to design a 100 volt breakdown diode, the required concentration is approximately 2.4 x 10¹⁷ cm⁻³ and will likewise require a depletion layer width at breakdown of 0.68 micrometers. Therefore, to prevent the thickness of the epitaxial layer, in this case the n-type layer, from being the limiting parameter for breakdown voltage, one typically exceeds this minimum depletion layer thickness. Thus, for such a 100 volt breakdown diode, the first epitaxial layer **12** should have a thickness on the order of at least 0.68 micrometers, and a carrier concentration of about 2.4 x 10¹⁷ cm⁻³. The substrate would have a carrier concentration of approximately one order of magnitude greater; while the second epitaxial layer **13** would have a carrier concentration about the same order of magnitude as the substrate. As set forth herein, the solid line portions of Figure 13 represent relationships based upon measured data, while the dotted portions represent the expected extrapolations from the measured relationships.

In particular, a rectifying diode according to the present invention will have a breakdown voltage (in volts) selected from along line AG of Figure 13 and which defines a directly opposite horizontal point on line CD. The corresponding depletion layer width (in micrometers) is selected from the point on line EF of Figure 13 that falls directly vertically beneath the defined point along line CD and the directly horizontally opposite point along line AG, and a corresponding carrier concentration (atoms/cm⁻³) is selected from the point on line GH of Figure 13 that falls directly vertically beneath the defined points along line CD and line EF.

The particular structure of the diode of the type shown in Figure 1 i.e. with the more densely populated n+ preferred substrate, n first epitaxial layer and p+ second epitaxial layer, gives a low forward resistance and a high breakdown voltage, and the more densely populated second epitaxial layer **13**, likewise tends to give an abrupt p-n junction. The result is a diode with a forward current characteristic of about 200 milliamperes at a forward voltage of three volts and a reverse breakdown voltage exceeding 400 volts. Previous diodes, such as the diodes described by Kuroda, demonstrate a forward current of only about 400 microamperes at the same 3 volt forward voltage. Similarly, Kuroda's diodes exhibit breakdown at -100 volts. Such a diode gives performance approximately 500 times as great in forward bias and four times as great in reverse bias than the prior art diodes.

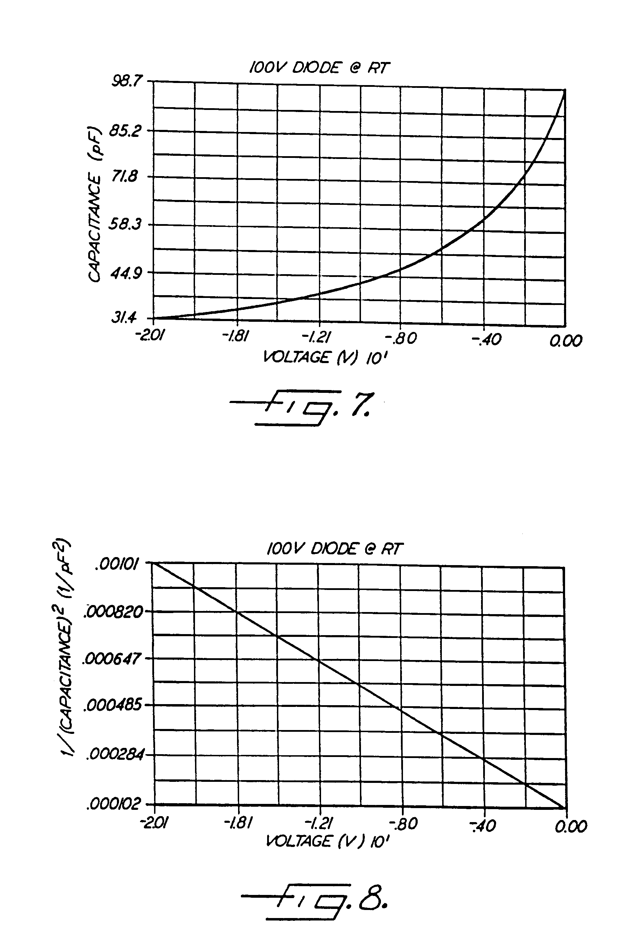

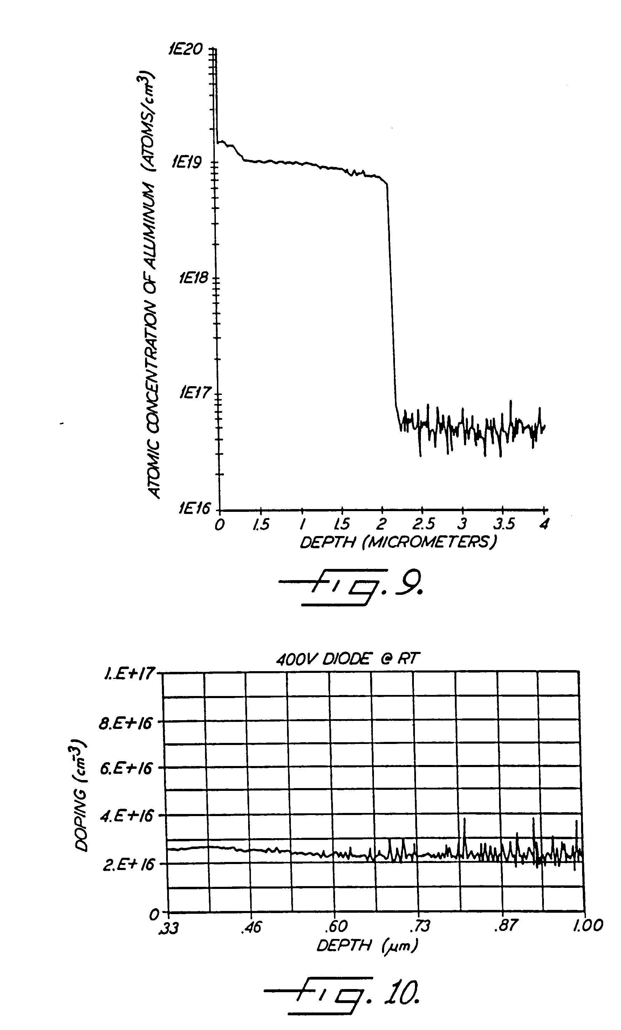

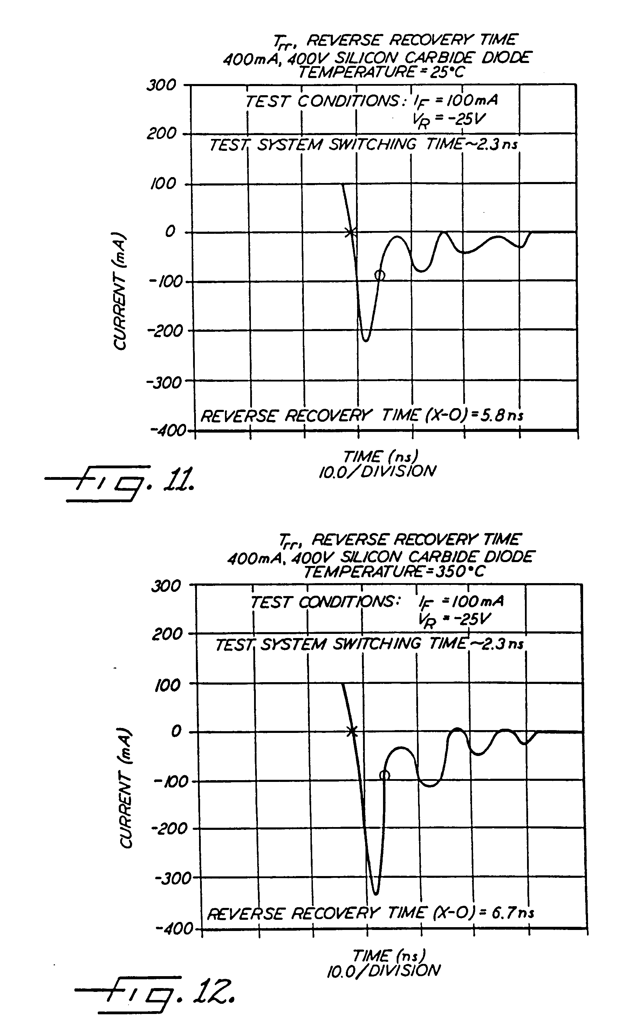

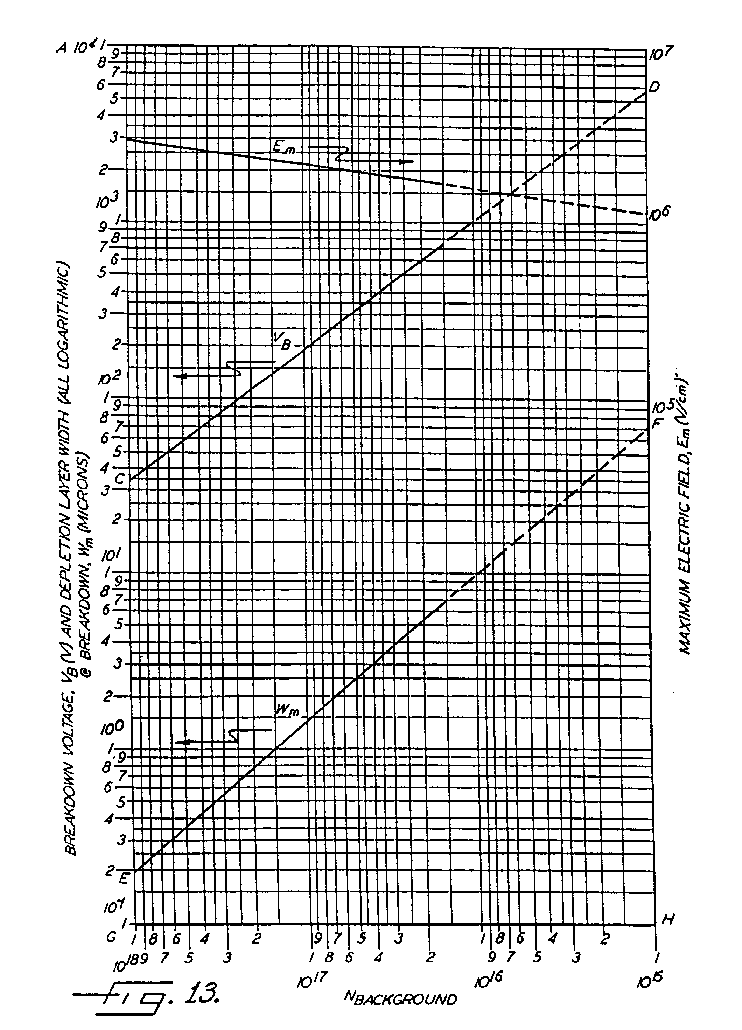

These particular results are best illustrated in the plots of Figures 5 and 6. Figure 5 shows that such a rectifying diode exhibits a reverse leakage current no greater than 80 microamperes at -400 volts while operating at a temperature of 350°C. Figure 6 shows the forward bias characteristics of the same diode at both 25°C and 350°C.

The use of a p+-n junction in the first embodiment results in the n-type epitaxial layer being the layer of the diode that is predominantly depleted at reverse bias. Nitrogen is a typical preferred n-type dopant and can be characterized as a "shallow" donor, with the result that variation in carrier concentration with temperature--and the resulting electrical characteristics of the diode--are more moderate than for a deeper level dopant. As is known to those familiar with such devices, carrier concentration in the lower doped epitaxial layer essentially controls the reverse bias characteristics of the device. Therefore, the carrier concentration should desirably be kept as constant as possible.

Figures 3 and 4 illustrate an embodiment of the present invention in which the n-type epitaxial layer has the greater carrier concentration, and the p-type layer is the layer that is resultingly predominantly depleted at reverse bias. Figure 3 illustrates an n+-type substrate **20** formed of monocrystalline silicon carbide, a first monocrystalline epitaxial layer **21** of silicon carbide upon the substrate **20** and having the same n+-type conductivity, and a second monocrystalline epitaxial layer **22** upon the first epitaxial layer **21** that has an opposite p-type conductivity type from the first epitaxial layer **21**. As symbolized by the n+ and p-designations, the first epitaxial layer **21** has a carrier concentration at least an order of magnitude greater than the second epitaxial layer **22** so that the second epitaxial layer **22** is predominantly depleted at reverse bias. In a most preferred embodiment, a third monocrystalline epitaxial layer **23** is upon the second epitaxial layer **22** and has the same p-type conductivity as the second epitaxial layer **22** and preferably has a carrier concentration greater than the carrier concentration of the second epitaxial layer **22** for reducing the contact resistance to the entire diode. As in the earlier embodiments, the Davis-type CVD provides an abrupt p-n junction between the first and second epitaxial layers **21** and **22** respectively.

Although not specifically illustrated for the sake of clarity, the diodes include respective ohmic contacts to the substrate and to the second epitaxial layer, or to the third epitaxial layer where one is present.

It has been found in accordance with the present invention that this embodiment provides excellent diode characteristics. Under certain circumstances a p-type layer can be somewhat inappropriate as the layer predominantly depleted at reverse bias because of the greater effect of temperature on the concentration of activated p-type dopants that is theoretically expected. In actuality, however, it has been experimentally determined that the p-type epitaxial layer is somewhat compensated by donor atoms that are otherwise present, so that the population of the p-type layer does not fluctuate as much with temperature as would be theoretically expected.

By using an unintentionally compensated p-layer as the layer predominantly depleted at reverse bias, a smaller carrier concentration can be achieved in that layer. The smaller carrier concentration in turn provides a higher breakdown voltage for the diode: a highly desireable result. As is known to those familiar with silicon carbide, uncompensated n-type crystals or epitaxial layers cannot be produced with carrier concentrations less than about 1 x 10¹⁶cm⁻³. This is generally due to the nature of the CVD growth process and the purity of the source gases used.

These limitations on minimum carrier concentration can be overcome with slight compensation of both n- and p- layers whereby carrier populations as low as 5 x 10¹⁴cm⁻³ can be achieved. This results in the higher breakdown voltages described above. In this embodiment, reverse breakdown voltages of as high as -5000 volts are expected over temperature ranges of between -55°C and 350°C. Similarly, forward current of up to 10 amperes at forward voltages of as low as 2.7 volts are possible over temperature ranges of about 20°C to 350°C. Additionally, the diodes operate with reverse recovery times of less than 20 nanoseconds, and usually less than 10 nanoseconds. Of course, as understood by those familiar with semiconductor diodes, for any particular diode the physical size of the device will limit or permit certain performance characteristics. Thus, larger junctions permit larger current flow at a given rated forward voltage.

Figure 4 shows an alternative, hexagonal geometry for the diodes of the present invention. The hexagonal geometry offers alternative advantages with respect to the circular mesa diode illustrated in Figure 2. Although the hexagonal geometry does present corners, they are relatively shallow. Moreover, the hexagonal geometry presents a larger junction area for the same size die and is simpler to package in a glass-encapsulated device.

Figures 14 and 15 demonstrate some additional characteristics of the diodes of the present invention formed in 6H-SiC and measured and plotted as current versus voltage (I-V) at room temperature (Fig. 14) and 350°C (Fig. 15). The particular device had an n+ substrate, an n+ first epitaxial layer, a p- second epitaxial layer, and a p+ third epitaxial layer. At room temperature a peak inverse voltage (PIV) of 455 volts (V) is reached whereupon avalanche breakdown occurs. The breakdown initially occurs at about 420V with a reverse leakage current of 4 microamperes, increasing to 50 microamperes at 450V. Thereafter the device operates in avalanche with current increasing linearly with voltage. The right hand side of Figure 14 illustrates the forward bias characteristics of this device. The bandgap of 6H-SiC is about 2.9 electron-volts (eV) at room temperature. This gives a built-in junction potential, corresponding to the turn-on voltage of the diode, in the range of about 2.4 to 2.5V. Thereafter, current rapidly increases with voltage, limited by the series resistance of the SiC. In other words, if resistance were totally absent (a practical impossibility), the current would be unlimited, but the turn-on voltage would remain in the 2.4 to 2.5V range at room temperature.

Figure 15 shows the current-voltage characteristics of the diode operating at 350°C. In reverse bias the breakdown voltage remains the same. The pre-breakdown voltage, however, characterized by the rounded knee in the curve between -400 and -450V, increases slightly. This increase may be due to thermally generated carriers other than those that contribute to the reverse saturation current (Jₛ) of the diode. At 350°C, Jₛ is about 10⁻¹⁴ amperes/cm².

When the diode is heated to 350°C, the turn-on voltage decreases to about 2.0V. This decrease in voltage with increased temperature may be a result of the reduction in bandgap of the material and thus an increase in the intrinsic carrier concentration.

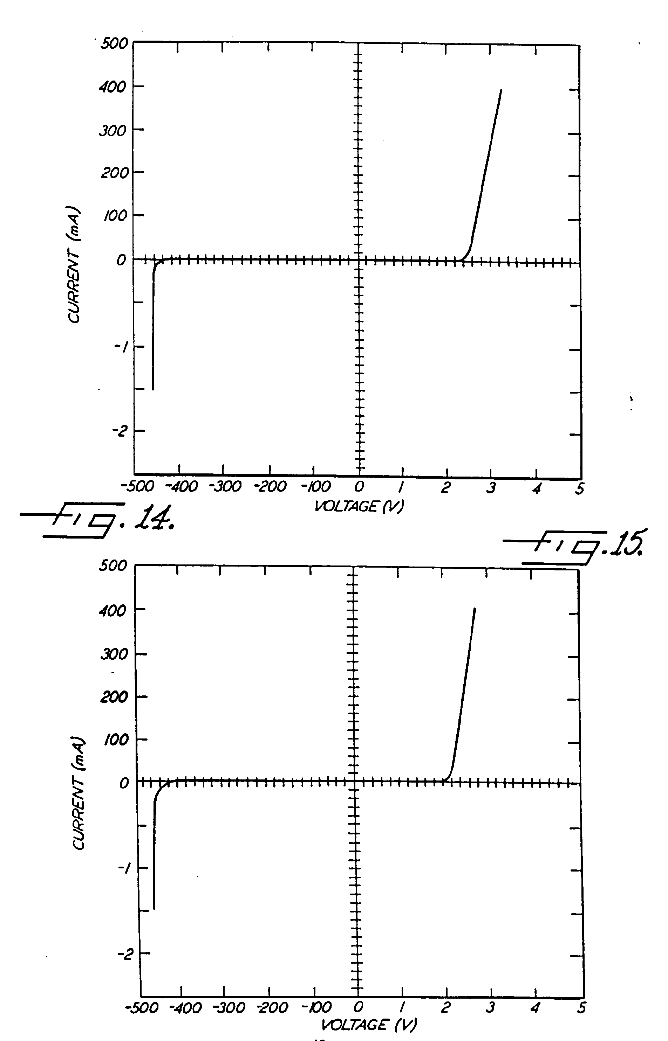

Figures 7 and 8 demonstrate the characteristics of the abrupt junctions in the diodes formed according to the present invention. Figure 7 is a plot of capacitance taken directly against applied voltage and shows the nonlinear, but proportional increase of capacitance as voltage becomes more positive. More importantly, Figure 8 shows that when the reciprocal of capacitance squared is plotted against the applied voltage, a substantially linear relationship is developed which demonstrates that the junction is abrupt rather than graded. As discussed earlier with respect to prior devices, where the reciprocal of capacitance squared plotted against voltage remains nonlinear and instead the reciprocal of capacitance cubed plotted against voltage becomes linear, the junction is graded, a situation which results in a lower breakdown voltage device and a diode which cannot operate as quickly.

Figure 9 relates to a rectifier such as that shown in Figure 1 and shows the results of another measurement technique that confirms the results demonstrated by Figure 8. As set forth in the description of the drawings, Figure 9 is a SIMS plot of the aluminum (acceptor atom in p+ epitaxial layer) population and its change as the p-n junction is crossed. The sharp vertical drop shown in the graph indicates that the acceptor atom population changes rapidly and drastically at the junction, giving the diode of the present invention its desired properties. Figure 10 shows the carrier concentration of the uncompensated n-type epitaxial layer as determined by capacitance-voltage measurements. As shown here and is reflected in Fig. 13, a diode showing a V_{BR} of 580V results from a carrier concentration of approximately 2.2 x 10¹⁶ cm⁻³ in the n-type layer.

Diodes formed according to the present invention also demonstrate the ability to operate at high frequencies; i.e. they can rectify a high frequency alternating current. As is known to those familiar with such devices, when reverse bias is applied to a rectifying diode, and the diode operates to block the flow of reverse current, a depletion region is built up adjacent the junction. This region has a certain capacitance which takes time to dissipate after the reverse bias is removed and the forward bias is applied.

This time period is known as the reverse recovery time (tᵣᵣ). In silicon carbide, the minority carrier lifetime is very low and therefore reverse recovery time, which is directly proportional to minority carrier lifetime, should be very short. Nevertheless, prior to the present invention, rectifying p-n junctions good enough to provide a measurable reverse recovery time had never been demonstrated. As illustrated graphically in Figures 11 and 12, the rectifying diodes of the present invention, however, have demonstrated sufficient quality to permit experimental measurement of reverse recovery time data. Maximum reverse recovery times as short as between about 5 and 8 nanoseconds maximum have been determined. Similar performance at even higher temperatures is correspondingly expected. Typically, in silicon, a rectifying diode with reverse recovery time of 100 to 200 nanoseconds would be considered fast. Schottky diodes are somewhat faster, but are limited in reverse bias to approximately -200 volts. Thus, the reverse recovery time is a characteristic of any given specific device. Diodes formed according to the present invention have consistently been demonstrated to have reverse recovery times less than 10 nanoseconds.

The rectifying diodes of the present invention are formed according to the disclosures of Davis et al set forth earlier herein describing a successful chemical vapor deposition method for growing silicon carbide epitaxial layers on off-axis silicon carbide substrates. For the sake of definition and clarity, the chemical vapor deposition techniques disclosed in the incorporated references are referred to as "Davis-type" chemical vapor deposition. In the diodes that are produced using Davis-type CVD the substrate comprises alpha silicon carbide and has a flat interface surface that is inclined more than one degree off axis with respect to a basal plane thereof substantially towards one of the <112̅0> directions. As used herein, the Miller designation "2̅" represents a "negative" axis in the Miller index system; i.e. an axis measured in the direction opposite the basic Miller index axis selected for the crystal. The first epitaxial layer also comprises alpha silicon carbide and is homoepitaxially deposited on the substrate interface surface.

Because epitaxial layers can be doped while being grown, they do not require implantation, and the crystal damage that can result from implantation can be avoided. Furthermore, implantation techniques would not permit adjacent n and n+ or p and p+ layers. An n+ layer could be implanted on an n layer, but an n layer could not be implanted on an n+ layer without compensation (i.e the presence of active amounts of both donor and acceptor atoms) of the n+ layer.

Additionally, CVD growth allows thickness control which to some extent allows control of the resulting depletion layer and thus, effects breakdown voltage. Finally, crystal characteristics of epitaxial layers are generally better structurally and carry less impurities than do bulk growth layers.

In the embodiments discussed herein, the illustrative data have been gathered from diodes formed from alpha type 6H silicon carbide. Other polytypes, however, can be prepared as the epitaxial layers and substrates and have characteristic advantages. For example, the 4H, 15R and 3C polytypes can all be fashioned into diodes according to the present invention. The 6H polytype has a wide band gap, is therefore expected to perform at high temperatures, and is most commonly produced in bulk form. The 4H polytype has the highest band gap (3.2 eV), shallower aluminum and nitrogen doping levels, and a greater electron mobility than the 6H polytype. The 3C polytype likewise has a higher electron mobility than does the 6H and a shallower band gap and corresponding lower built in potential for a p-n junction. Finally, the 15R polytype has a lower activation energy for nitrogen dopant than does the 6H polytype, along with a higher electron mobility.

As will be understood by those familiar with rectifying diodes and their manufacture and properties, once a particular set of characteristics are established, the manufacture of diodes having wide ranging properties can be accomplished. Therefore, the properties of diodes according to the present invention having been demonstrated, it is expected that diodes having reverse breakdown voltages as great as -5000 volts are possible as part of the present invention. Such diodes are expected to exhibit such properties at temperature ranges extending from about -55°C to at least 350°C. Selected embodiments of the diodes will exhibit reverse leakage currents no greater than 25 microamperes up to their given rated reverse breakdown voltages. In other embodiments reverse leakage currents no greater than 100 microamperes will be exhibited at temperatures up to 350°C, and particular embodiments have demonstrated reverse leakage currents no greater than 8 microamperes at -400 volts at 25°C.

Forward currents of 400 milliamperes at 2.9 volts at a temperature of 350°C have been demonstrated. At room temperature (25°C) forward currents of 400 milliamperes at 3.2 volts are typically observed, and 400 milliampere current at as low as 2.7 volts has also been observed.

Reverse recovery times less than 200 nanoseconds have been demonstrated, as have tᵣᵣ's of less than 100, 20, and 10 nanoseconds, and as set forth earlier herein, specific embodiments have demonstrated reverse recovery times less than 6 nanoseconds at 25°C and less than 7 nanoseconds at 350°C.

It will be understood that such rectifying diodes are characteristically rated by their maximum exemplary performance values. Thus, diodes according to the present invention, and the claims set forth hereinafter, also cover otherwise similar and equivalent diodes which may exhibit somewhat less than the various exemplary characteristics set forth herein.

In the drawings and specification, there have been disclosed typical preferred embodiments of the invention and, although specific terms have been employed, they have been used in a generic and descriptive sense only and not for purposes of limitation, the scope of the invention being set forth in the following claims.

## Claims

1. A fast recovery, high temperature rectifying diode formed in silicon carbide and comprising:
a monocrystalline silicon carbide substrate having n-type conductivity;
an ohmic contact to said substrate;
a first monocrystalline epitaxial layer of n-type silicon carbide upon said substrate; and
a second monocrystalline epitaxial layer of silicon carbide upon said first epitaxial layer;
characterized in that:
said second epitaxial layer has p-type conductivity and a carrier concentration at least an order of magnitude less than the carrier concentration of said first epitaxial layer so that said second layer is predominantly depleted in reverse bias with said carrier concentration of said second layer being between about 1x10¹⁵ and 1x10¹⁸atoms per cubic centimeter (cm⁻³), and said second layer further having a minimum thickness of about 0.2 micrometers at a carrier concentration of about 1x10¹⁸cm⁻³ and that may be increased proportionally to a thickness of about 70 micrometers at a carrier concentration of about 1x10¹⁵ cm⁻³ so that said minimum thickness is sufficient to achieve avalanche breakdown under reverse bias; and
an abrupt p-n junction formed between said first and second epitaxial layers such that the relationship between the reciprocal capacitance squared and the applied voltage is a substantially linear relationship.

2. A rectifying diode according to Claim 1 and further comprising a third epitaxial layer upon said second epitaxial layer and wherein said third epitaxial layer has the same conductivity type as said second epitaxial layer and has a carrier concentration greater than said second epitaxial layer for reducing the contact resistance to said diode.

3. A rectifying diode according to Claim 1 wherein said silicon carbide substrate comprises alpha silicon carbide and has a flat interface surface that is inclined more than one degree off axis with respect to a basal plane thereof substantially towards one of the <112̅0> directions, and with said first epitaxial layer comprising alpha silicon carbide homoepitaxially deposited on said substrate interface surface.

4. A rectifying diode according to Claim 1 further comprising a passivation layer of thermally grown silicon dioxide adjacent said junction.

5. A rectifying diode according to Claim 1 further comprising an ohmic contact to said substrate and formed of nickel, and an ohmic contact to said second epitaxial layer and formed of a bimetallic alloy containing aluminum.

6. A rectifying diode according to Claim 1 wherein said silicon carbide has a single polytype selected from the group consisting of the 6H, 3C, 4H and 15R polytypes.

7. A rectifying diode according to Claim 1 having a forward current of at least 400 milliamperes at a forward voltage of as low as 2.7 volts while operating at a temperature of 25°C.

8. A rectifying diode according to Claim 1 having a forward current of at least 400 milliamperes at a forward voltage of as low as 2.2 volts while operating at a temperature of 350°C.

9. A rectifying diode according to Claim 1 having a reverse leakage current no greater than 25 microamperes up to a given rated reverse breakdown voltage while operating at a temperature of 25°C.

10. A rectifying diode according to Claim 1 having a reverse leakage current no greater than 100 microamperes up to a given rated reverse breakdown voltage while operating at a temperature of 350°C.

11. A rectifying diode according to Claim 1 having a reverse leakage current no greater than 8 microamperes at -400 volts while operating at a temperature of 25°C.

12. A rectifying diode according to Claim 1 having a reverse leakage current no greater than 80 microamperes at -400 volts while operating at a temperature of 350°C.

13. A rectifying diode according to Claim 1 having a reverse recovery time less than 200 nanoseconds.

14. A rectifying diode according to Claim 1 having a reverse recovery time less than 10 nanoseconds.

15. A rectifying diode according to Claim 1 having a reverse recovery time as small as 6 nanoseconds or less at an operating temperature of 25°C.

16. A rectifying diode according to Claim 1 having a reverse recovery time as small as 7 nanoseconds or less at an operating temperature of 350°C.

17. A rectifying diode according to Claim 1 having a reverse breakdown voltage as high as -5000 volts while operating at a temperature range of between -55°C and 350°C.

18. A rectifying diode according to Claim 1 having a reverse recovery time less than 20 nanoseconds.

## Patentansprüche

1. Schnelle Hochtemperatur-Freilaufgleichrichterdiode, die auf der Basis von Siliciumkarbid gebildet ist und aufweist:
ein einkristallines Siliciumkarbidsubstrat, welches n-Leitfähigkeit hat,
einen Ohm'schen Kontakt an dem Substrat,
eine erste einkristalline epitaktische Schicht aus Siliciumkarbid mit n-Leitfähigkeit auf dem Substrat, und
eine zweite einkristalline epitaktische Schicht aus Siliciumkarbid auf der ersten epitaktischen Schicht,
**dadurch gekennzeichnet**, daß
- die zweite epitaktische Schicht p-Leitfähigkeit und eine Ladungsträgerkonzentration hat, die um zumindest eine Größenordnung geringer ist als die Ladungsträgerkonzentration der ersten epitaktischen Schicht, so daß die zweite Schicht überwiegend in umgekehrter Vorspannung abgereichert ist mit einer Ladungsträgerkonzentration dieser zweiten Schicht, welche zwischen etwa 1 x 10¹⁵ und 1 x 10¹⁸ Atomen pro Kubikzentimeter (cm⁻³⁾ liegt, und wobei diese zweite Schicht weiterhin eine minimale Dicke von etwa 0,2 Mikrometer bei einer Ladungsträgerkonzentration von etwa 1 x 10¹⁸ cm⁻³ hat, und daß jene proportional auf eine Dicke von etwa 70 Mikrometer bei einer Ladungsträgerkonzentration von etwa 1 x 10¹⁵ cm⁻³ erhöht werden kann, so daß diese minimale Dicke ausreicht, um unter umgekehrter Vorspannung einen Spannungsdurchbruch zu erzielen, und
daß ein abrupter p-n-Übergang zwischen der ersten und der zweiten epitaktischen Schicht gebildet wird, so daß das Verhältnis zwischen dem Kehrwert der Kapazität zum Quadrat zu der angelegten Spannung eine im wesentlichen lineare Beziehung ist.

2. Gleichrichterdiode nach Anspruch 1, welche weiterhin eine dritte epitaktische Schicht auf der zweiten epitaktischen Schicht aufweist, und wobei die dritte epitaktische Schicht von demselben Leitfähigkeitstyp ist wie die zweite epitaktische Schicht und eine Ladungsträgerkonzentration hat, die größer ist als die der zweiten epitaktischen Schicht, um den Kontaktwiderstand der Diode zu vermindern.

3. Gleichrichterdiode nach Anspruch 1, wobei das Siliciumkarbidsubstrat Alphasilikonkarbid aufweist und eine ebene Übergangsfläche hat, deren Achse um mehr als ein Grad gegenüber einer Achse einer Grundebene desselben geneigt ist, im wesentlichen in Richtung einer der <112̅0> Richtungen, und wobei die erste epitaktische Schicht Alphasiliciumkarbid aufweist, welches gleichermaßen epitaktisch auf der Übergangsfläche des Substrates abgeschieden ist.

4. Gleichrichterdiode nach Anspruch 1, dadurch gekennzeichnet, daß sie weiterhin eine Passivierungsschicht aus thermisch erzeugtem Siliciumdioxid an bzw. neben dem Übergang aufweist.

5. Gleichrichterdiode nach Anspruch 1, welche weiterhin ein Ohm'schen Kontakt an dem Substrat aufweist, welcher aus Nickel gebildet ist, sowie einen Ohm'schen Kontakt an der zweiten epitaktischen Schicht und welcher aus einer Legierung aus zwei Metallen besteht, welche Aluminium enthält.

6. Gleichrichterdiode nach Anspruch 1, wobei das Siliciumkarbid einen einzigen Polytypus hat, der aus der Gruppe ausgewählt ist, welcher aus den Polytypen 6H, 3C, 4H und 15R besteht.

7. Gleichrichterdiode nach Anspruch 1, welche einen Strom in Durchlaßrichtung von zumindest 400 Milliampere bei einer Durchlaßspannung von nur 2,7 Volt hat, wenn sie bei einer Temperatur von 25°C betrieben wird.

8. Gleichrichterdiode nach Anspruch 1, welche einen Durchlaßstrom von zumindest 400 Milliampere bei einer Durchlaßspannung von nur 2,2 Volt hat, wenn sie bei einer Temperatur von 350°C betrieben wird.

9. Gleichrichterdiode nach Anspruch 1, welche einen umgekehrten Leckstrom von nicht mehr als 25 Mikroampere bis zu einer gegebenen, veranschlagten Durchbruchspannung hat, wenn sie bei einer Temperatur von 25°C betrieben wird.

10. Gleichrichterdiode nach Anspruch 1, welche einen umgekehrten Leckstrom (in Sperrichtung) von nicht mehr als 100 Mikroampere bis zu einer gegebenen, veranschlagten Durchbruchspannung hat, wenn sie bei einer Temperatur von 350°C betrieben wird.

11. Gleichrichterdiode nach Anspruch 1, welche einen Leckstrom in Sperrichtung von nicht mehr als 8 Mikroampere bei -400 Volt hat, wenn sie bei einer Temperatur von 25°C betrieben wird.

12. Gleichrichterdiode nach Anspruch 1, welche einen Sperrleckstrom von nicht mehr als 80 Mikroampere bei -400 Volt hat, wenn sie bei einer Temperatur von 350°C betrieben wird.

13. Gleichrichterdiode nach Anspruch 1, welche eine Umkehrfreilaufzeit von weniger als 200 Nanosekunden hat.

14. Gleichrichterdiode nach Anspruch 1, welche eine Umkehrfreilaufzeit von weniger als 10 Nanosekunden hat.

15. Gleichrichterdiode nach Anspruch 1, welche eine Umkehrfreilaufzeit von nur 6 Nanosekunden oder weniger bei einer Betriebstemperatur von 25°C hat.

16. Gleichrichterdiode nach Anspruch 1, welche eine Umkehrfreilaufzeit von nur 7 Nanosekunden oder weniger bei einer Betriebstemperatur von 350°C hat.

17. Gleichrichterdiode nach Anspruch 1, welche eine Durchbruchspannung von -5000 Volt hat, wenn sie bei einer Temperatur im Bereich zwischen 55°C und 350°C betrieben wird.

18. Gleichrichterdiode nach Anspruch 1, welche eine Umkehrfreilaufzeit von weniger als 20 Nanosekunden hat.

## Revendications

1. Diode de redressement haute température à rétablissement rapide constituée en carbure de silicium et comprenant :
un substrat monocristallin en carbure de silicium ayant une conductivité de type n ;
une connexion conductrice avec ledit substrat ;
une première couche épitaxiale monocristalline de carbure de silicium de type n sur ledit substrat ; et
une seconde couche épitaxiale monocristalline de carbure de silicium sur ladite première couche épitaxiale ;
caractérisée en ce que :
ladite seconde couche épitaxiale a une conductivité de type p et une concentration de porteurs qui est inférieure d'au moins un ordre de grandeur à la concentration de porteurs de ladite première couche épitaxiale de sorte que ladite seconde couche est appauvrie de manière prédominante en polarisation inverse avec ladite concentration de porteurs de ladite seconde couche située entre environ 1.10¹⁵ et 1.10¹⁸ atomes par centimètre cube (cm⁻³), et ladite seconde couche ayant en outre une épaisseur minimum d'environ 0,2 micromètre à une concentration de porteurs d'environ 1.10¹⁸ cm⁻³ et celle-ci peut être augmentée proportionnellement à une épaisseur d'environ 70 micromètres à une concentration de porteurs d'environ 1.10¹⁵ cm⁻³ de sorte que ladite épaisseur minimum est suffisante pour obtenir un claquage par avalanche en polarisation inverse ; et
une jonction p-n abrupte formée entre lesdites première et seconde couches épitaxiales de sorte que la relation entre la capacitance mutuelle au carré et la tension appliquée est une relation sensiblement linéaire.

2. Diode de redressement selon la revendication 1 et comprenant en outre une troisième couche épitaxiale sur ladite seconde couche épitaxiale et dans laquelle ladite troisième couche épitaxiale a le même type de conductivité que ladite seconde couche épitaxiale et a une concentration de porteurs supérieure à celle de ladite seconde couche épitaxiale pour réduire la résistance de contact à ladite diode.

3. Diode de redressement selon la revendication 1, dans laquelle ledit substrat en carbure de silicium comprend du carbure de silicium alpha et a une surface interfaciale plate qui est inclinée de plus d'un degré hors de l'axe par rapport à un plan de base de celle-ci sensiblement vers une des directions <112̅0>, et avec ladite première couche épitaxiale comprenant du carbure de silicium alpha déposé homoepitaxialement sur ladite surface interfaciale du substrat.

4. Diode de redressement selon la revendication 1 comprenant en outre une couche de passivation constituée de dioxyde de silicium grandi thermiquement adjacente à ladite jonction.

5. Diode de redressement selon la revendication 1 comprenant en outre une connexion conductrice avec ledit substrat et formé de nickel, et une connexion conductrice avec ladite seconde couche épitaxiale et formée d'un alliage bimétallique contenant de l'aluminium.

6. Diode de redressement selon la revendication 1, dans laquelle ledit carbure de silicium a un polytype simple choisi dans le groupe constitué des polytypes 6H, 3C, 4H et 15R.

7. Diode de redressement selon la revendication 1 ayant un courant direct d'au moins 400 milliampères pour une tension directe aussi faible que 2,7 Volts tout en fonctionnant à une température de 25°C.

8. Diode de redressement selon la revendication 1 ayant un courant direct d'au moins 400 milliampères pour une tension directe aussi faible que 2, 2 Volts tout en fonctionnant à une température de 350°C.

9. Diode de redressement selon la revendication 1 ayant un courant inverse de fuite pas supérieur à 25 microampères jusqu'à une tension nominale inverse de claquage donnée tout en fonctionnant à une température de 25°C.

10. Diode de redressement selon la revendication 1 ayant un courant inverse de fuite pas supérieur à 100 microampères jusqu'à une tension nominale inverse de claquage donnée tout en fonctionnant à une température de 350°C.

11. Diode de redressement selon la revendication 1 ayant un courant inverse de fuite pas supérieur à 8 microampères à - 400 Volts tout en fonctionnant à une température de 25°C.

12. Diode de redressement selon la revendication 1 ayant un courant inverse de fuite pas supérieur à 80 microampères à - 400 Volts tout en fonctionnant à une température de 350°C.

13. Diode de redressement selon la revendication 1 ayant un temps de recouvrement inverse inférieur à 200 nanosecondes.

14. Diode de redressement selon la revendication 1 ayant un temps de recouvrement inverse inférieur à 10 nanosecondes.

15. Diode de redressement selon la revendication 1 ayant un temps de recouvrement inverse aussi faible que 6 nanosecondes ou moins à une température de fonctionnement de 25°C.

16. Diode de redressement selon la revendication 1 ayant un temps de recouvrement inverse aussi faible que 7 nanosecondes ou moins à une température de fonctionnement de 350°C.

17. Diode de redressement selon la revendication 1 ayant une tension inverse de claquage aussi élevée que -5000 Volts tout en fonctionnant dans un domaine de température situé entre - 55°C et 350°C.

18. Diode de redressement selon la revendication 1 ayant un temps de recouvrement inverse inférieur à 20 nanosecondes.
